(19) Europäisches Patentamt
European Patent Office
Office européen des brevets

(11) **EP 0 861 514 B1**

(12) **EUROPÄISCHE PATENTSCHRIFT**

(45) Veröffentlichungstag und Bekanntmachung des Hinweises auf die Patenterteilung:
**01.10.2003 Patentblatt 2003/40**

(21) Anmeldenummer: **97933621.1**

(22) Anmeldetag: **04.07.1997**

(51) Int Cl.$^7$: **H02H 7/085**

(86) Internationale Anmeldenummer:
**PCT/DE97/01413**

(87) Internationale Veröffentlichungsnummer:
**WO 98/012786 (26.03.1998 Gazette 1998/12)**

(54) **ANORDNUNG ZUR ERKENNUNG VON EINKLEMMSITUATIONEN BEI ELEKTRISCHEN ANTRIEBEN**

JAMMING DETECTION DEVICE FOR ELECTRICAL DRIVES

INSTALLATION POUR DETECTER DES BLOCAGES DANS DES MOTEURS ELECTRIQUES

(84) Benannte Vertragsstaaten:
**DE ES FR GB IT**

(30) Priorität: **16.09.1996 DE 19637631**

(43) Veröffentlichungstag der Anmeldung:
**02.09.1998 Patentblatt 1998/36**

(73) Patentinhaber: **ROBERT BOSCH GMBH**
**70442 Stuttgart (DE)**

(72) Erfinder:
• **KNECHT, Gerhard**
**D-76473 Iffezheim (DE)**
• **PREIS, Karl-Heinrich**
**D-77830 Bühlertal (DE)**
• **PRÜSSEL, Holger**
**D-77830 Bühlertal (DE)**

(56) Entgegenhaltungen:
**EP-A- 0 275 238      EP-A- 0 328 838**
**US-A- 4 952 854**

## Beschreibung

Stand der Technik

Die Erfindung geht aus von einer Anordnung zur Erkennung von Einklemmsituationen bei elektrischen Antrieben, die insbesondere für Fensterhebe- und Schiebedachvorrichtungnen in Kraftfahrzeugen vorgesehen sind, der im Oberbegriff des Anspruchs 1 definierten Gattung.

Bei einer bekannten Schaltungsanordnung dieser Art (DE 28 20 330 C2) ist ein Motor vorgesehen, der über ein Schaltelement gesteuert wird, welches seinerseits von einer Motorüberwachungsstufe beeinflußt wird. Die Motorüberwachungsstufe leitet aus einem bestimmten statischen Motorstromwert ein Rücksetzsignal ab und erkennt außerdem zumindest zeitweise aus einer bestimmten zeitlichen Änderung des Motorstroms ein weiteres Rücksetzsignal. Bei dieser bekannten Anordnung wird eine statische und eine dynamische Stromüberwachung durchgeführt. Dadurch wird der Motor abgeschaltet oder dessen Drehrichtung umgekehrt, wenn etwa beim Auftreffen der Scheibe auf ein Hindernis eine schnelle Momentänderung bzw. Stromerhöhung auftritt, auch wenn der momentane Stromwert vergleichsweise gering ist. Der Motor wird aber auch dann abgeschaltet oder dessen Drehrichtung umgekehrt, wenn bei einem schleichenden Stromanstieg auf einen Wert nahe dem Kurzschlußstrom eine weitere rasche Stromerhöhung nicht mehr möglich ist. Hier werden also zwei Kriterien, nämlich der statische Motorstrom und die zeitliche Änderung des Motorstroms zur Erkennung von Einklemmsituationen ausgewertet.

Aus der US-A 4,952,854 ist eine Steuerschaltung für einen Elektromotor bekannt geworden, mit der ein Einklemmschutz realisiert werden kann. Das von dem eingesetzten Gleichstrommotor bereitgestellte Drehmoment ist proportional zum Motorstrom. Der Proportionalitätsfaktor hängt von den Konstruktionsdaten des Gleichstrommotors ab. Eine Kenngröße ist hierbei der Ankerwiderstand, der bei stillstehendem Motor aus der am Motor anstehenden Spannung und dem durch den Motor fließenden Strom ermittelt werden kann. Der Motorstillstand wird bei der vorbekannten Steuerschaltung erreicht durch einen im Motorstromkreis angeordneten Widerstand, der bei einer vorgegebenen Betriebsspannung den Motorstrom auf einen derart niedrigen Wert begrenzt, bei dem der Motor nicht anlaufen kann. Nach Ablauf einer vorgegebenen Zeit wird der im Motorstromkreis angeordnete Widerstand überbrückt und der normale Motorbetrieb aufgenommen. Aus dem aufgrund der gemessenen Größen errechneten Drehmoment und der errechneten Drehzahl wird mit einer Integration die Position der Motorwelle ermittelt. Anhand eines Vergleiches einer Drehmomentänderung bezogen auf eine Positionsänderung und einem Vergleich dieses Wertes mit einem vorgegebenen maximalen Drehmoment, wobei entsprechende Wertepaare in einem Referenzspeicher hinterlegt sind, kann eine Einklemmsituation erkannt werden.

Allgemein ist es auch bekannt, zur Kraftbegrenzung und zum Einklemmschutz bei Verstellantrieben, wie Fensterhebern und Schiebedachantrieben in Kraftfahrzeugen, eine Drehzahlüberwachung durchzuführen und die beispielsweise mit Hallsensoren ermittelte Drehzahl entsprechend auf schleichende und abrupte Änderungen hin zu überwachen sowie die notwendigen Motorsteuersignale daraus abzuleiten.

Vorteile der Erfindung

Die erfindungsgemäße Anordnung geht demgegenüber einen prinzipiell völlig anderen, sehr vorteilhaften Weg. Zum Erkennen von Einklemmsituationen und zum Realisieren des Einklemmschutzes wird bei der erfindungsgemäßen Anordnung mit den kennzeichnenden Merkmalen des Anspruchs 1 als Maß die im Anker des Motors induzierte Spannung verwendet, wobei die induzierte Spannung aus der an den Motorklemmen anstehenden Spannung und dem im Anker des Motors fließenden Strom ermittelt wird.

Durch die in den weiteren Ansprüchen niedergelegten Maßnahmen sind vorteilhafte Weiterbildungen und Verbesserungen der im Anspruch 1 angegebenen Anordnung zum Erkennen von Einklemmsituationen möglich.

In vorteilhafter Ausgestaltung der Erfindung wird entsprechend einer besonders zweckmäßigen Ausführungsform der Erfindung die induzierte Spannung als Differenz aus der an den Motorklemmen anstehenden Spannung und dem Produkt aus Ankerstrom und Ankerwiderstand ermittelt. Entsprechend einer sehr zweckmäßigen Ausgestaltung dieser Ausführungsform wird der Ankerwiderstand regelmäßig ermittelt, insbesondere bei jedem neuen Lauf des Motors.

Gemäß einer besonders zweckmäßigen Weiterbildung der Erfindung wird der Ankerwiderstand aus der an den Motorklemmen anstehenden Spannung und dem Blockierstrom des Motors ermittelt. In vorteilhafter Ausgestaltung wird dabei der Blockierstrom durch Extrapolation des zu einem bestimmten Zeitpunktes gemessenen Ankerstromes ermittelt.

Eine für die einfache und zuverlässige Realisierung der Erfindung besonders zweckmäßige Ausgestaltung der Erfindung sieht vor, daß der im Anker fließende Strom über einen Shunt-Widerstand gemessen und gegebenenfalls verstärkt und mittels eines Analog-Digital-Wandlers zu einem Stromsignal digitalisiert wird.

In weiterer vorteilhafter und besonders zweckmäßiger Ausgestaltung der Erfindung wird das aus dem im Anker fließenden Strom ermittelte Stromsignal mit Hilfe eines Integrators, der von einem Mikrokontroller gesteuert ist, mit anpaßbaren, berechneten Integrationszeiten gemittelt.

Gemäß einer sehr zweckmäßigen Ausführungsform dieser Ausgestaltung der Erfindung wird das aus dem im Anker fließenden Strom ermittelte Stromsignal über mehrere Kommutierungsperioden aufintegriert, insbesondere über 3 bis 5 Kommutierungsripples.

In vorteilhafter Weiterbildung dieser Ausführungsform der Erfindung ist vorgesehen, daß die Integration des aus dem im Anker fließenden Strom ermittelten Stromsignals bei Überschreiten eines Schwellwertes unterbrochen, der ermittelte Wert digitalisiert und gespeichert wird, die Integration erneut begonnen wird und dieser Vorgang solange fortgesetzt wird, bis die gesamte angepaßte und vorgesehene Integrationszeit abgelaufen ist.

Entsprechend einer vorteilhaften und realistischen Ausgestaltung der Erfindung wird zur Auslösung des Einklemmschutzes derjenige im Anker fließende Strom bestimmt, welcher bei aktueller Auslösung größer sein muß als ein Wert, der sich zusammensetzt aus einem gemittelten Wert des Ankerstromes, aus einem die Änderung der Versorgungsspannung über den Zeitraum der Mittelung berücksichtigenden Korrekturwert und aus einem Auslösewert, gemäß folgender Gleichung:

$$I_{An\,ker} > \overline{I_{an\,ker}} + \frac{U_{B_n} - U_{B_{n-1}}}{R_{An\,ker}} + I_S$$

In weiterer zweckmäßiger Ausgestaltung der Erfindung werden die gemessenen Ankerstromwerte in einem Speicher, insbesondere einem Ringpuffer, gespeichert und mit dem aktuellen Meßwert wird der jeweils älteste Meßwert im Speicher überschrieben.

Zeichnung

Die Erfindung ist anhand eines in der Zeichnung dargestellten Ausführungsbeispiels in der nachfolgenden Beschreibung näher erläutert. Es zeigen:

Fig. 1    den Verlauf des Motorstroms zusammen mit überlagerten Kommutierungsschwankungen;

Fig. 2    schematisch ein Blockschaltbild eines Teils der erfindungsgemäßen Anordnung, und

Fig. 3    schematisch den Integrationsverlauf des Ankerstromes bzw. des daraus abgeleiteten Stromsignals sowie den daraus gewonnenen Spannungsverlauf am Meßwiderstand.

Beschreibung des Ausführungsbeispiels

Gemäß der Erfindung wird die im Gleichstrommotor induzierte Spannung $U_{ind}$ als Maß für das Erkennen einer Einklemmsituation ermittelt. Diese im Anker des Motors induzierte Spannung $U_{ind}$ ist meßtechnisch nicht direkt zugänglich. Sie wird daher gemäß vorliegender Erfindung aus der an den Motorklemmen anstehenden Spannung $U_{Kl}$ und dem im Anker des Motors fließenden Strom $I_A$ ermittelt. Entsprechend einer vorteilhaften Ausführungsform erfolgt dies bei Kenntnis des Ankerwiderstandes $R_A$ als Differenz aus der an den Motorklemmen anstehenden Spannung $U_{Kl}$ und dem Produkt aus Ankerstrom $I_A$ und Ankerwiderstand $R_A$ gemäß folgender Gleichung:

$$U_{Ind} = U_{Kl} - R_A \cdot I_A \ .$$

Der Ankerwiderstand $R_A$ ist großen Toleranzen unterworfen, wie beispielsweise Fertigungstoleranzen und Temperaturschwankungen. Daher wird entsprechend zweckmäßiger Ausgestaltung der Erfindung der Ankerwiderstand $R_A$ regelmäßig im System ermittelt. Es ist dabei von besonderem Vorteil, wenn er jeweils zu Beginn eines Motorlaufs erneut ermittelt wird und den anschließenden Berechnungsschritten zu Grunde gelegt wird.

Der im Anker des Motors fließende Strom $I_A$ ändert sich mit der Zeit t nach einer Exponentialfunktion. Im Leerlauf gilt:

$$I(t) = I_{Block} \cdot e^{-\left(\frac{t}{\tau_{mech}}\right)}$$

mit $\tau_{mech}$ als mechanischer Zeitkonstanten des Ankers, d.h. dessen Trägheit darstellend.

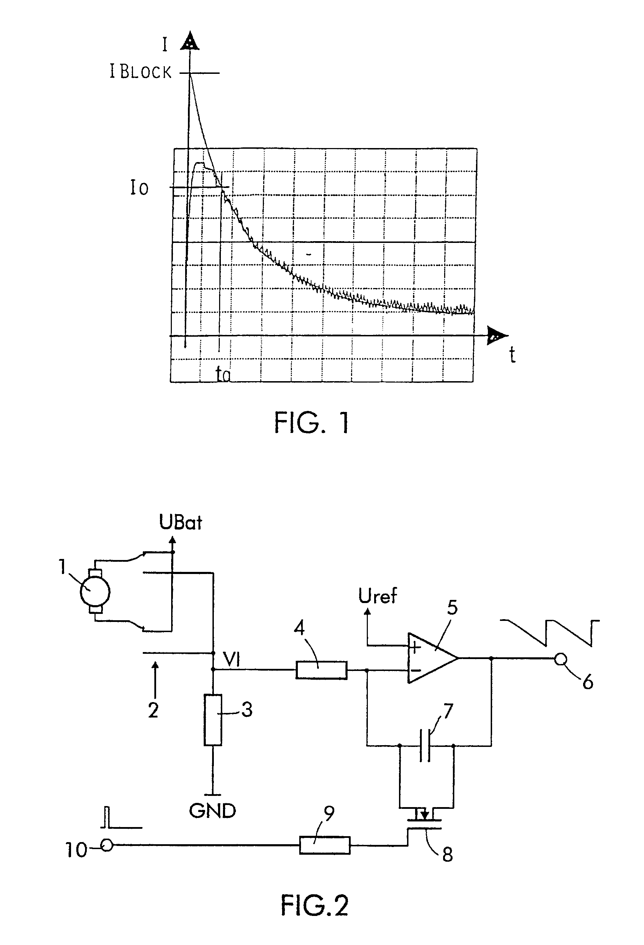

In Fig. 1 ist der typische Verlauf des Motorstroms I zusammen mit überlagerten Kommutierungsschwankungen über der Zeitachse t aufgetragen. Der Ankerstrom wird durch die Ankerinduktivität begrenzt. Daher fließt zum Einschaltzeitpunkt nicht der Blockierstrom $I_{block}$, sondern es ergibt sich ein exponentiell ansteigender Ankerstrom mit der elektrischen Zeitkonstanten $\tau_{elektrisch}$, die wesentlich kleiner ist als $\tau_{mech}$. Die Anlaufstromspitze erreicht nicht den vollen Blockierstrom $I_{block}$, da sich der Anker des Motors bereits zu drehen beginnt, während die elektrische Zeitkonstante $\tau_{elektrisch}$ verstreicht. Das Verhältnis von Blockierstrom zu Anlaufstromspitze hängt nur von den beiden Zeitkonstanten $\tau_{mech}$ und $\tau_{elektrisch}$ ab, und ist damit konstant. Der Ankerwiderstand $R_A$ wird zu Beginn jedes Motorstarts aus der am Motor anliegenden Klemmenspannung $U_{Kl}$ und dem Blockierstrom $I_{block}$, jeweils zum Zeitpunkt $t_0$ nach dem Start, ermittelt: $R_A = U_{kl} / I_{block}$. Für die Dauer eines Motorlaufs wird der Ankerwiderstand als konstant angenommen. Genau genommen ist dies zwar nicht der Fall, stellt aber bei der Annahme von nur wenigen Sekunden Laufzeit für den Motor eine gute Näherung dar.

Wie in der Darstellung des Motorstroms in Fig. 1 gezeigt, sind dem eigentlich in einer Exponentialform verlaufenden Motorstrom $I_A$, bzw. dem daraus resultierenden Motorstromsignal, Kommutierungsschwankungen überlagert. Die Amplitude dieser sogenannten Ripples liegt in der Größenordnung der Signaländerungen, welche durch eine Einklemmsituation hervorgerufen werden. Aus diesem Grund müssen diese Kommutierungsripples eliminiert werden. Entsprechend einer besonders vorteilhaften Ausführungsform der Erfindung wird dazu das Stromsignal über einen Zeitraum von mehreren Kommutierungsripples, insbesondere über einen Zeitraum von 3 bis 5 Ripples, gemittelt.

In dem in Fig. 2 dargestellten, schematischen Blockschaltbild der erfindungsgemäßen Anordnung ist mit 1 ein Gleichstrommotor dargestellt, der über ein Doppelrelais 2 entweder an die Spannung $U_{Bat}$ einer nicht dargestellten Kraftfahrzeugbatterie oder zur Messung des Motorstroms an einen Meßwiderstand 3, einen Shunt, anschließbar ist. Die eine Seite des Shunts 3 ist an Erdpotential GND gelegt, während der andere Anschluß über einen Widerstand 4 auf den invertierenden Eingang - eines Operationsverstärkers 5 geführt ist. Somit wird der gemessene Ankerstromwert des Motors 1, welcher am Shunt 3 abgegriffen und in ein Stromsignal V1 gewandelt ist, verstärkt. Der Ausgang 6 des Operationsverstärkers 5 ist auf den invertierenden Eingang über einen Kondensator 7 rückgekoppelt. Somit bildet der Operationsverstärker 5 zusammen mit dem Kondensator 7 einen Integrator. Am nichtinvertierenden Eingang + des Operationsverstärkers 5 liegt eine Referenzspannung $U_{ref}$ an, welche so gewählt ist, daß sie immer größer ist als die maximale Amplitude des Stromsignals V1, die dem Blockierstrom entspricht. Der Kondensator 7 ist durch einen Transistor 8, insbesondere in Form eines MOSFET, überbrückbar. Der Transistor 8 wird über einen Widerstand 9 vom Eingang 10 her mit einem Löschimpuls gesteuert.

Dadurch wird der Kondensator 7 bei Auftreten des Löschimpulses gesteuert kurzgeschlossen und entladen. Die Anfangsbedingung für eine Integration wird neu bestimmt und die Integration kann von neuem beginnen.

Das am Ausgang 6 des Operationsverstärkers 5 anstehende integrierte und verstärkte Stromsignal V1 wird einem nicht dargestellten Analog-Digital-Wandler sowie einem ebenfalls nicht dargestellten Mikrokontroller zur Auswertung zugeführt. Der Mikrokontroller generiert beispielsweise den am Eingang 10 zugeführten Löschimpuls zur Steuerung der Integration. Bei jedem zugeführten Löschimpuls wird der Kondensator 7 entladen und damit kann sich unmittelbar anschließend die Spannung am Ausgang 6 und am Kondensator 7 wieder aufbauen. Die Integration wird solange durchgeführt, wie es vom Mikrokontroller vorgegeben ist. Dabei wird durch Unterbrechung der Integration bei Erreichen eines bestimmten Spannungswertes und Aufaddieren der jeweiligen digitalisierten aufgelaufenen Werte, bis zum erreichten Spannungswert des Integrators am Ende der abgelaufenen vorgegebenen Integrationszeit.

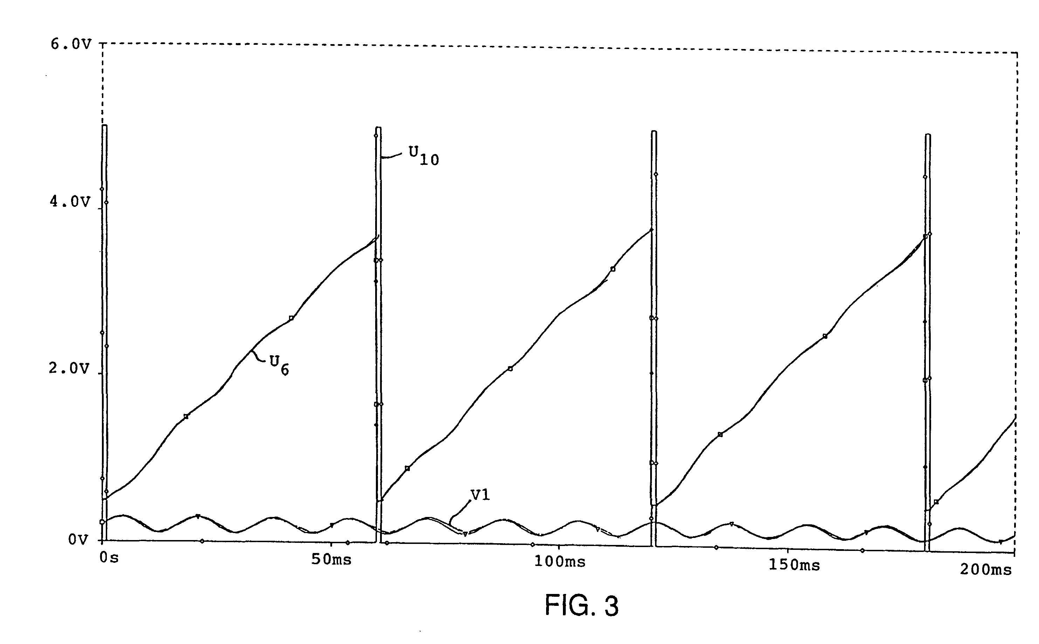

In Fig. 3 ist schematisch der Integrationsverlauf des Ankerstromes bzw. des daraus abgeleiteten Stromsignals V1, das als sinusförmig angenommen ist, dargestellt. Die dargestellte gesamte Integrationszeit ist mit 200 ms angenommen. Zur Vermeidung der Übersteuerung des Integrators wird bei Erreichen eines Schwellwerts von ca. 3,7V die Integration unterbrochen. Zu diesem Zweck wird der MOSFET 8 für ca. 1 ms eingeschaltet und dadurch der Kondensator 7 entladen. Im dargestellten Beispiel wird der Schwellwert dreimal erreicht und am Ende bei Erreichen der vollen vorgesehenen Integrationszeit von 200 ms liegt am Kondensator 7 bzw. dem Ausgang 6 des Operationsverstärkers 5 eine Spannung von ca. 1,5V, an. Der gesamte in der Integrationszeit von 200 ms erreichte Spannungswert liegt also bei ca. (3 x 3,7V) + 1,5V = ca. 12,6V. Dieser Wert ist digitalisiert vom Analog-Digital-Wandler erfaßt und steht für die Auswertung bereit.

Generell ist festzuhalten, daß die Integrationszeitkonstante des Integrators, gebildet im Kern aus Operationsverstärker 5 und Kondensator 7, so eingestellt wird, daß bei der Leerlaufdrehzahl des Motors 1 der Aussteuerbereich des Integrators fast ausgenutzt wird. Bei niedrigerer Drehzahl wird die Integrationszeitkonstante größer. Um die damit verbundene Übersteuerung des Integrators zu vermeiden, wird wie bereits oben erläutert, die Integration bei Erreichen eines bestimmten Schwellwertes unterbrochen. Zu diesem Zeitpunkt wird der Spannungswert mittel des Analog-Digital-Wandlers digitalisiert und die abgelaufene Integrationszeit wird von der an die Drehzahl angepaßten gesamten Integrationszeit subtrahiert. Nunmehr wird der Kondensator 7 mittels des über den Eingang 10 vom Mikrokontroller gelieferten Löschimpulses über den für ca. 1 ms leitend geschalteten Transistor 8 entladen und die Integration wird erneut gestartet. Diese Vorgehensweise wird solange fortgesetzt, bis die gesamte Integrationszeit abgelaufen ist, wobei die letzte Integration, wie bereits oben dargestellt, nicht durch Überschreiten eines Spannungspegels am Integratorausgang, sondern durch die abgelaufene Integrationszeit abgebrochen wird. Der Wert für den gemittelten Strom ergibt sich nach folgenden Gleichung:

$$\overline{I_A}(t) = \frac{1}{t_i} \cdot \int_{t}^{t+t_i} I_A(t) \cdot dt \quad \text{mit} \quad t_i = \frac{4}{N} \quad .$$

Dieses beschriebene Verfahren bietet die Möglichkeit, gesteuert vom Mikrokontroller, über eine feste Anzahl von Kommutierungsripples, hier vier, zu mitteln. Außerdem kann der Wertebereich eines 8-Bit Analog-Digital-Wandlers vergrößert werden, indem durch die Integration mehrmals unterbrochen wird und die einzelnen Integrationsergebnisse addiert werden. Dies ist besonders deshalb so wertvoll und vorteilhaft, weil der Dynamikbereich der Messung wegen der möglichen Schwankungen des Bordnetzes zwischen 9 und 15V sowie der erheblichen Geschwindigkeitsvariationen des Motors sehr groß ist.

Entsprechend einer vorteilhaften Weiterbildung der grundlegenden Idee vorliegender Erfindung ist es möglich, denjenigen Ankerstrom zu bestimmen, der den Einklemmschutz auslöst, wobei in zweckmäßiger Weise die Auslöseschwelle an die aktuelle Bordnetzspannung, d.h. beispielsweise an die Spannung $V_{bat}$ der Batterie des Kraftfahrzeuges, angepaßt wird.

Wenn bei konstantem Lastmoment des Motors die Motorklemmenspannung $U_{kl}$ springt, so macht der Ankerstrom $I_A$ aufgrund der Massenträgheit des Motors und des angeschlossenen Systems ebenfalls einen Sprung. Der Anstieg des Stromes wird nur durch die Ankerinduktivität verzögert. Ist der Ankerwiderstand $R_A$ bekannt, so gilt:

$$\frac{dI_{an\,ker}}{dt} = \frac{1}{R_{An\,ker}} \cdot \frac{dU_{Klemme}}{dt}$$

Der Grenzwert der Stromänderung muß daher mit der Änderung der Klemmenspannung dividiert durch den Ankerwiderstand $R_A$, $dU_{Kl}/R_A$, korrigiert werden. Nach Ablauf einiger mechanischer Zeitkonstanten des Systems hat sich die Geschwindigkeit des Ankers wieder stabilisiert, und das Ankermoment bzw. der dazu proportionale Ankerstrom hat wieder den alten Wert angenommen.

Der Grenzwert ergibt sich aus einer Mittelung über die vergangenen Strommeßwerte, zu dem das oben angegebene Korrekturglied addiert wird. Durch die nachfolgenden Mittelungen wird der Mittelwert wieder an den aktuellen Ankerstrom angenähert. Die Mittelung simuliert somit die mechanische Zeitkonstante des Ankers, d.h. dessen Trägheit.

Der Ablauf des Meß- und Auswerteverfahrens ist wie folgt, wobei in vorteilhafter Weise ein Mikrokontroller verwendet wird.

Die Ankerstrommeßwerte werden in einem Speicher, der bevorzugt ein Ringpufferspeicher ist, gespeichert. Mit dem aktuellen Meßwert wird der älteste Meßwert im Ringpuffer überschrieben. Die Mittelung erfolgt durch Summation aller Meßwerte im Ringpuffer und Division der erhaltenen Summe durch die Anzahl der Meßwerte. Zu von dem Mikrokontroller vorgegebenen Zeitpunkten werden der so gemittelte Strom und die aktuelle Bordnetzspannung gemessen. Der Korrekturterm für den mittleren Strom ergibt sich aus der Differenz der aktuellen Bordnetzspannung $UB_n$ zu der bei der vorangegangenen Messung ermittelten Bordnetzspannung $UB_{n-1}$, die durch den Ankerwiderstand $R_A$ dividiert wird. Als Auslösekriterium für den Einklemmschutz kann dann die folgende Bedingung verwendet werden:

$$I_{An\,ker} > \overline{I_{an\,ker}} + \frac{U_{B_n} - U_{B_{n-1}}}{R_{An\,ker}} + I_S$$

dabei ist $I_S$ eine Auslöseschwelle, die sicherstellt, daß nur signifikante Änderungen des Ankerstroms zum Auslösen des Einklemmschutzes führen.

Nachfolgend werden anhand einer praktisch Ausführung die einzelnen Anschnitte eines realisierten, programmierten Ablaufs dargestellt.

Vor dem Einschalten oder Wiedereinschalten des Motors wird zunächst die Leerlaufspannung des Integrators, wobei der Ankerstrom gleich Null ist, ermittelt. Sie ist Grundlage für alle weiteren Messungen. Da die Steigung der Integratorausgangsspannung in diesem Betrieb ihren größten Wert hat, darf die Meßzeit nicht zu groß gewählt werden. Weiterhin sollte sie leicht, insbesondere durch Shiftoperationen, auf die Meßzeit für die Ermittlung des Blockierstroms umgerechnet werden können. In der praktischen Ausführung wurde eine Leerlaufintegrationszeit von 8ms gewählt.

Als nächstes wird das Strommaximum ermittelt. Zur Messung des Blockierstroms wird, wie zur Messung des mittleren Ankerstroms, der Integrator verwendet. Es werden kurze Meßzeiten, in der praktischen Ausführung 2ms, gewählt, und es werden solange fortlaufend Messungen durchgeführt, bis das Strommaximum überschritten ist. Dem Strommaximum entspricht ein Minimum der Integratorspannung am Ausgang 6 in Fig. 2, da der Integrator invertierend wirkt. Zur Berechnung des Integrationsergebnisses wird zunächst die Integrationsausgangsspannung von einer Integrationszeit von 2ms auf 8ms umgerechnet. Dabei wird für diese Umrechnung die Annahme einer für die Integrationszeit von 2ms konstanten Eingangsgröße für den Integrator gemacht. Damit ergibt sich:

$$U_a\Big|_{(8ms)} = \frac{1}{\tau} \cdot \int_0^{8ms} (U_{Ref} - U_e(t))dt \approx 4 \cdot \frac{1}{\tau} \cdot \int_0^{2ms} (U_{Ref} - U_e(t)) \cdot dt$$

und als Maß für den maximalen Ankerstrom erhält man mit

$$U_e(t) = R_{Shunt} \cdot I_{Anker}:$$

$$R_{Shunt} \cdot \frac{1}{\tau} \int_0^{8ms} I_{Anker\,max} \cdot dt \approx R_{Shunt} I_{Anker_{max}} \frac{8ms}{\tau} \approx \frac{8ms}{\tau} U_{ref} - 4 \cdot U_a\Big|_{min}$$

Die Berechnung des Ankerwiderstandes ist der nächste Schritt. Der Blockierstrom $I_{block}$ des Ankers wird durch Multiplikation des Strommaximums mit einer Konstanten errechnet, die empirisch ermittelt werden kann. Im vorliegenden praktischen Fall ist die Konstante zu 1,25 ermittelt worden.

Sofort nach Messung des Ankerstromintegrals wird die Motorklemmenspannung gemessen. Ein Maß für den Ankerwiderstand erhält man durch Division der aktuellen Klemmenspannung $U_{bat}$ bzw. $H_{anker}$ durch den Blockierstrom $I_{block}$ des Ankers:

$$R_{Anker} = \frac{U_{anker}}{I_{Block}} = \frac{U_{Anker}}{1.25 \cdot I_{Anker_{max}}}$$

Anstelle des Ankerstrommaximums ist jedoch nur die mit der Integrationszeitkonstanten $\tau$ normierte und mit dem konstanten Shuntwiderstand multiplizierte Meßgröße zugänglich. Damit ergibt sich anstelle des Ankerwiderstandes $R_A$ ein normierter Ankerwiderstand R:

$$\hat{R} = \frac{U_{Anker}}{1.25 \cdot I_{Anker_{max}} \cdot R_{shunt} \cdot \frac{8ms}{\tau}} = \frac{R_{Anker}}{R_{Shunt}} \cdot \frac{\tau}{8ms}$$

Zur Berechnung dieses Quotienten ist es erforderlich, daß der Wert von $U_{bat}$ zunächst mit einer Hilfskonstanten, im vorliegenden praktischen Fall 32,5 mal shift, multipliziert wird, damit man bei der Division genügend signifikante Stellen für den normierten Ankerwiderstand $\hat{R}$ erhält.

Nun zur Berechnung des gemittelten Ankerstroms. Zur Erfassung des aktuellen Ankerstroms bei gleichzeitiger Eliminierung der Kommutierungsschwankungen wird der Ankerstrom mittels des Integrators über eine Intergrationszeit T gemittelt. Es ergibt sich hier:

$$\frac{1}{\tau}\int_0^T U_e(t)\cdot dt = \frac{R_{Shunt}}{\tau}\cdot\int_0^T I_{Anker}(t)\cdot dt = \frac{T}{\tau}\cdot U_{ref} - U_a(T)$$

$$= R_{Shunt}\cdot\frac{T}{\tau}\cdot\bar{I}_{Anker} = \hat{\bar{I}}_{Anker}$$

Die erste Intergrationszeit T nach Bestimmung des Ankerwiderstandes wird auf einen festen Wert, hier 10ms, festgelegt. Zur Bestimmung des Stromintegrals wird wieder zuerst die Intergatorleerlaufspannung auf diese Meßzeit T skaliert nach der Beziehung:

$$\frac{T}{\tau}\cdot U_{ref} = \frac{T_{LL}}{\tau}\cdot U_{ref}\cdot\frac{T}{T_{LL}}$$

Mit der im vorigen Absatz angegebenen Gleichung erhält man einen normierten, gemittelten Ankerstrom $\hat{\bar{I}}$.

Letztlich erfolgt die Berechnung der induzierten Spannung $U_{ind}$ mit Hilfe der Größen Motorklemmenspannung $U_{kl}$, normiertem Ankerwiderstand $\hat{R}$ und normiertem, gemitteltem Ankerstrom $\hat{\bar{I}}$.

$$\hat{R}\cdot\hat{\bar{I}} = \frac{R_{Anker}}{R_{Shunt}}\cdot\frac{\tau}{8ms}\cdot\frac{T}{\tau}\cdot R_{Shunt}\cdot\bar{I}_{Anker} = R_{Anker}\cdot\bar{I}_{Anker}\cdot\frac{T}{8ms}$$

damit ergibt sich für die induzierte Spannung $U_{ind}$

$$U_{ind} = U_{Anker} - R_{Anker}\cdot\bar{I}_{Anker} = U_{Anker} - \hat{R}\cdot\hat{\bar{I}}\cdot\frac{8ms}{T}$$

Aus dem Wert von $U_{ind}$ wird über eine ROM-Tabelle die zukünftige Integrationszeit ermittelt. Bei der beschriebenen praktischen Ausführungsform der Erfindung variieren die Intergrationszeiten zwischen 5ms und 31,5ms mit einer Quantisierung von 500μs, wobei die Rechenzeit bei der Quotientenbildung ja zu berücksichtigen ist.

**Patentansprüche**

1. Anordnung zur Erkennung von Einklemmsituationen bei elektrischen Antrieben, die insbesondere für Fensterhebe- und Schiebedachvorrichtungnen in Kraftfahrzeugen vorgesehen sind,
   **dadurch gekennzeichnet, daß**
   als Maß für das Erkennen einer Einklemmsituation die im Anker des Motors (1) induzierte Spannung ($U_{ind}$) verwendet ist, und
   daß die induzierte Spannung ($U_{ind}$) aus der an den Motorklemmen anstehenden Spannung ($U_{bat}$) und dem im Anker des Motors (1) fließenden Strom ($I_A$) ermittelt wird.

2. Anordnung nach Anspruch 1, **dadurch gekennzeichnet, daß** die induzierte Spannung ($U_{ind}$) als Differenz aus der an den Motorklemmen anstehenden Spannung ($U_{bat}$) und dem Produkt aus Ankerstrom ($I_A$) und Ankerwiderstand ($R_A$) ermittelt wird.

3. Anordnung nach Anspruch 1 oder 2, **dadurch gekennzeichnet, daß** der Ankerwiderstand ($R_A$) regelmäßig ermittelt wird, insbesondere bei jedem neuen Lauf des Motors (1).

4. Anordnung nach Anspruch 3, **dadurch gekennzeichnet, daß** der Ankerwiderstand ($R_A$) aus der an den Motorklemmen anstehenden Spannung ($U_{bat}$) und dem Blockierstrom ($I_{block}$) des Motors (1) ermittelt wird.

5. Anordnung nach Anspruch 4, **dadurch gekennzeichnet, daß** der Blockierstrom ($I_{block}$) durch Extrapolation des zu einem bestimmten Zeitpunkt ($t_0$) gemessenen Ankerstromes ($I_A$) ermittelt wird.

6. Anordnung nach einem der vorigen Ansprüche, **dadurch gekennzeichnet, daß** der im Anker fließende Strom ($I_A$) über einen Shunt-Widerstand (3) gemessen und gegebenenfalls verstärkt (5) und mittels eines Analog-Digital-Wandlers zu einem Stromsignal digitalisiert wird.

7. Anordnung nach einem der vorigen Ansprüche, **dadurch gekennzeichnet, daß** das aus dem im Anker fließenden Strom ($I_A$) ermittelte Stromsignal (V1) mit Hilfe eines Integrators (5, 7), der von einem Mikrokontroller gesteuert ist, mit anpaßbaren, berechneten Integrationszeiten gemittelt wird.

8. Anordnung nach einem der vorigen Ansprüche, **dadurch gekennzeichnet, daß** das aus dem im Anker fließenden Strom ($I_A$) ermittelte Stromsignal (V1) über mehrere Kommutierungsperioden aufintegriert wird, insbesondere über 3 bis 5 Kommutierungsripples.

9. Anordnung nach einem der Ansprüche 8 oder 9, **dadurch gekennzeichnet, daß** die Integration des aus dem im Anker fließenden Strom ($I_A$) ermittelten Stromsignals (V1) bei Überschreiten eines Schwellwertes unterbrochen, der ermittelte Wert digitalisiert und gespeichert wird, die Integration erneut begonnen wird und dieser Vorgang solange fortgesetzt wird, bis die gesamte angepaßte und vorgesehene Integrationszeit abgelaufen ist.

10. Anordnung nach einem der vorigen Ansprüche, **dadurch gekennzeichnet, daß** zur Auslösung des Einklemmschutzes derjenige im Anker fließende Strom ($I_A$) bestimmt wird, welcher bei aktueller Auslösung größer sein muß als ein Wert, der sich zusammensetzt aus einem gemittelten Wert des Ankerstromes ($I_A$), aus einem die Änderung der Versorgungsspannung über den Zeitraum der Mittelung berücksichtigenden Korrekturwert (($U_{bn} - U_{bn-1}$)/$R_A$)) und aus einem Auslösewert ($I_S$) gemäß folgender Gleichung:

$$I_{An\,ker} > \overline{I_{an\,ker}} + \frac{U_{B_n} - U_{B_{n-1}}}{R_{An\,ker}} + I_S$$

11. Anordnung nach Anspruch 10, **dadurch gekennzeichnet, daß** die gemessenen Ankerstromwerte in einem Speicher, insbesondere einem Ringpuffer, gespeichert werden und daß mit dem aktuellen Meßwert der jeweils älteste Meßwert im Speicher überschrieben wird.

**Claims**

1. Arrangement for detecting jamming situations in electric drives which are provided, in particular, for window lifting and sliding roof devices in motor vehicles, **characterized in that** the voltage ($U_{ind}$) induced in the armature of the motor (1) is used as a measure for detecting a jamming situation, and **in that** the induced voltage ($U_{ind}$) is determined from the voltage ($U_{bat}$) present across the motor terminals and from the current ($I_A$) flowing in the armature of the motor (1).

2. Arrangement according to Claim 1, **characterized in that** the induced voltage ($U_{ind}$) is determined as the difference between the voltage ($U_{bat}$) present across the motor terminals and the product of the armature current ($I_A$) and armature resistance ($R_A$).

3. Arrangement according to Claim 1 or 2, **characterized in that** the armature resistance ($R_A$) is determined regularly, in particular with each new run of the motor (1).

4. Arrangement according to Claim 3, **characterized in that** the armature resistance ($R_A$) is determined from the voltage ($U_{bat}$) present across the motor terminals and the blocking current ($I_{block}$) of the motor (1).

5. Arrangement according to Claim 4, **characterized in that** the blocking current ($I_{block}$) is determined by extrapolating the armature current ($I_A$) measured at a specific instant ($t_0$).

6. Arrangement according to one of the preceding claims, **characterized in that** the current ($I_A$) flowing in the armature is measured via a shunt resistor (3) and, if appropriate, amplified (5) and is digitized by means of an analog-to-digital converter to form a current signal.

7. Arrangement according to one of the preceding claims, **characterized in that** the current signal (V1) determined from the current ($I_A$) flowing in the armature is averaged with the aid of an integrator (5, 7) which is controlled by a microcontroller and has adaptable, calculated integration times.

8. Arrangement according to one of the preceding claims, **characterized in that** the current signal (V1) determined from the current ($I_A$) flowing in the armature is integrated over a plurality of commutation periods, in particular over 3 to 5 commutation ripples.

9. Arrangement according to either of Claims 8 and 9, **characterized in that** the integration of the current signal (V1) determined from the current ($I_A$) flowing in the armature is interrupted upon overshooting of a threshold value, the value determined is digitized and stored, the integration is begun anew and this procedure is continued until the total adapted and provided integration time has expired.

10. Arrangement according to one of the preceding claims, **characterized in that**, in order to trigger the anti-jamming system, that current ($I_A$) flowing in the armature is determined which must be greater in the event of current triggering than a value that is composed of an average value of the armature current ($I_A$), of a correction value (($U_{bn}$ - $U_{bn-1}$)/$R_A$)) taking account of the change in the supply voltage over the period of the averaging, and of a triggering value ($I_S$) in accordance with the following equation:

$$I_{armature} > \overline{I_{armature}} + \frac{U_{B_n} - U_{B_{n-1}}}{R_{armature}} + I_S$$

11. Arrangement according to Claim 10, **characterized in that** the measured armature current values are stored in a memory, in particular a ring buffer, and **in that** the respective oldest measured value is overwritten in the memory by the current measured value.

**Revendications**

1. Installation pour détecter des blocages dans des moteurs électriques, en particulier pour des lève-vitres ou des ferme-toits électriques dans les véhicules
   **caractérisée en ce que**
   comme mesure pour détecter une situation de blocage, on utilise la tension induite ($U_{ind}$) dans l'induit du moteur, et la tension induite ($U_{ind}$) est déterminée à partir de la tension ($U_{bat}$) aux bornes du moteur et du courant ($I_A$) passant dans l'induit du moteur (1).

2. Installation selon la revendication 1,
   **caractérisée en ce que**
   la tension induite ($U_{ind}$) est déterminée par la différence entre la tension aux bornes du moteur ($U_{bat}$) et le produit entre le courant d'induit $I_A$ et la résistance d'induit $R_A$.

3. Dispositif selon la revendication 1 ou 2,
   **caractérisée en ce que**
   la résistance d'induit ($R_A$) est déterminée régulièrement, en particulier à chaque nouveau démarrage du moteur (1).

4. Dispositif selon la revendication 3,
   **caractérisée en ce que**

la résistance d'induit ($R_A$) est déterminée à partir de la tension aux bornes du moteur ($U_{bat}$) et le courant de blocage ($I_{bloc}$) du moteur 1.

5. Dispositif selon la revendication 4,
**caractérisée en ce que**
le courant de blocage ($I_{bloc}$) est déterminé par extrapolation du courant d'induit ($I_A$) à l'instant précis (tO).

6. Dispositif selon l'une des revendications précédentes,
**caractérisé en ce que**
le courant traversant l'induit ($I_A$) est mesuré à travers une résistance de court-circuit (3) et le cas échéant amplifié (5) et est numérisé pour former un signal de courant au moyen d'un convertisseur analogique-numérique.

7. Dispositif selon l'une des revendications précédentes,
**caractérisé en ce que**
le signal de courant (V1) déterminé à partir du courant ($I_A$) traversant l'induit est obtenu à l'aide de temps d'intégration adaptable, par calcul au moyen d'un intégrateur (5,7) commandé par un micro-contrôleur.

8. Dispositif selon l'une des revendications précédentes,
**caractérisé en ce que**
le signal de courant (V1) déterminé à partir du courant traversant l'induit ($I_A$) est intégré sur plusieurs périodes de commutation, en particulier sur trois à cinq ondulations de commutation.

9. Installation selon l'une des revendications 8 ou 9,
**caractérisée en ce que**
l'intégration du signal de courant (V1) déterminé à partir du courant traversant l'induit ($I_A$) est interrompue par le dépassement d'une valeur de seuil, la valeur déterminée est numérisée et mémorisée, puis l'intégration reprend de nouveau et ce processus est renouvelé jusqu'à ce qu'à la fin de la totalité du temps d'intégration adapté et prévu.

10. Installation selon l'une des revendications précédentes,
**caractérisée en ce que**
pour déclencher la protection de blocage on détermine le courant $I_A$ traversant l'induit qui pour un déclenchement actuel doit être plus grand qu'une valeur composée à partir d'une valeur moyenne du courant d'induit ($I_A$), d'une valeur de correction prenant en compte la modification de la tension d'alimentation pendant l'intervalle de temps au cours duquel on calcule la moyenne (($U_{bn}$ - $U_{bn-1}$)/$R_A$)et d'une valeur de déclenchement $I_s$ selon l'équation suivante :

$$I_{ind} > \overline{I_{ind}} + \frac{U_{B_n} - U_{B_{n-1}}}{R_{ind}} + I_S$$

11. Dispositif selon la revendication 10,
**caractérisée en ce que**
les valeurs de courant d'induit mesuré sont mémorisées dans une mémoire, en particulier une mémoire tampon en boucles et que la valeur de mesure actuelle remplace à chaque fois la plus ancienne des valeurs de mesure.

**EP 0 861 514 B1**

FIG. 1

FIG.2

11

FIG. 3

EP 0 861 514 B1